# EUROPEAN PATENT APPLICATION

(11) **EP 2 541 706 A2**
(43) Date of publication of application: **02.01.2013**
(21) Application number: 12172533.7
(22) Date of filing: 19.06.2012
(51) Int. Cl.: H02G 3/08, H02G 15/007, H05K 9/00

(54) **Connection arrangement for an electric cable**

(30) Priority: 28.06.2011 FI 20114076 U
(71) Applicant: Vacon Oyj, 65380 Vaasa (FI)
(72) Inventor: Pussinen, Matti, 66400 Laihia (FI)
(74) Representative: Heinänen, Pekka Antero

(57) **Abstract**

Arrangement for connecting an electric cable (14) to a power electronics device, such as to a frequency converter, which device is protected with an enclosure, through the wall structure of which enclosure the cable is arranged, and in which arrangement the cable is supported for reducing the mechanical stressing of the electrical connections (cable clamping). The invention is achieved so that the arrangement comprises an electrically conductive metal bushing flange (31), through which the cable (14) is arranged to pass into the enclosure, which flange (31) is fixed to the wall structure of the enclosure, e.g. with screws, and which flange (31) comprises at least one fixing tongue (35) for fixing the cable clamp bars (43) of the cable.

## Description

### Field of technology

The object of the present invention is an arrangement for connecting an electric cable to a power electronics device, such as to a frequency converter, which device is protected with an enclosure, through the wall structure of which enclosure the cable is arranged, and in which arrangement the cable is supported for reducing the mechanical stressing (cable clamping) of the electrical connections.

Preferably the object of the invention is the arranging of a lead-in of a cable through a wall structure of an enclosure surrounding a device such that the pertinent EMC requirements, clamping requirements and/or sealing requirements will be met.

### Prior art

Power transformers, e.g. frequency converters, based on modern fast semiconductor components are known to spread highfrequency electromagnet interference into their environment. According to industry standards, the interference is divided into interference (frequency range 30 - 1000 MHz) spreading into the surrounding space directly by radiating and interference (frequency range 0.15 - 30 MHz) spreading into other devices along the cables connected to the device.

EMC standards for specific devices set limits for permitted emissions of interference, meeting the requirements of which limits can e.g. make it necessary to use a metal protective enclosure around a device. Meeting the requirements can also result in a device being connected to its environment with a cable having a metal protective sheath that is earthed as imperviously as possible to the enclosure for achieving a so-called Faraday cage around the conductors producing interfering emissions.

A reliable installation method requires that no overlarge mechanical stressing is exerted on any electrical connections, owing to which so-called cable clamping that supports the cable is generally arranged in the proximity of the connections.

The purpose of an enclosure surrounding an electrical device is, apart from preventing contact with dangerous parts, also to protect a device from the detrimental ingress of foreign objects, dust and splashes. At the point of the apertures made for the lead-ins of cables this generally requires careful sealing.

A known method for earthing the sheath of a cable in a manner meeting EMC requirements is to strip the insulating sheath surrounding the cable from the proximity of connections for the necessary distance and to install in this point a metal earthed band that surrounds the exposed metal sheath as imperviously as possible on every side (so-called 360° earthing).

Cable clamping is generally arranged in the same way as EMC earthing, by installing around an unstripped cable a tight band that is able to bear the mechanical tensile stressing exerted on the cable and that is fixed to a structure of the enclosure.

Meeting the mechanical enclosure class, e.g. IP54, promised for an electrical device can require preventing the detrimental ingress of dust and of splashing from any direction. At the point of the lead-in of a cable the requirement is implemented e.g. with a rubber seal, which tightly blocks the free space surrounding the cable in the lead-in aperture.

A problem with the solutions listed above is, *inter alia,* that the fixing supporting the earthing band and clamping band requires space on both sides of the cable and a suitable structure that is in connection with the frame of the enclosure. The space requirement hampers implementation of the lead-ins of a number of cables disposed close to each other. Cables of different thicknesses require bands of different sizes, which itself also causes problems in the installation phase. The immovability of the rubber seal required by the enclosure class can also be uncertain without a special mechanical pressing into position.

### Summary of the invention

The purpose of this invention is to achieve a new type of arrangement, with which the aforementioned drawbacks are avoided and a cable lead-in fitting into a small space is enabled, which lead-in comprises both 360° earthing, cable clamping and also the sealing required by the enclosure class. This aim is achieved with the arrangement according to the invention, which is characterized by what is disclosed in the characterization part of the independent claim. Other preferred embodiments of the invention are the objects of the dependent claims.

The bushing flange according to the invention is preferably a one-piece part surrounding the cable in a ring-like manner, which part is fabricated from a mechanically strong material that conducts electricity well, e.g. from aluminium. The bushing flange is fixed into the enclosure of the device such that there is a good electrically conductive contact between the flange and the enclosure and the lead-in hole for the cable remains symmetrically inside it. The flange has at least one, preferably two, tongues in the longitudinal direction of the cable, to which tongues the cable clamping arms can be fixed. The 360° earthing of the sheath of the cable is done with a flexible metal sock, which is pressed with separate clamps around both the metal sheath of the cable and the outer rim of the bushing flange. The inside rim of the flange has a groove, which ensures that the lead-in seal ensuring the tightness of the enclosure stays in its position.

The lead-in part according to the invention with its associated installation accessories can be threaded into its position in the phase when the end of the cable is pushed inside the enclosure from the lead-in hole, before making the electrical connections. Since the part requires only a little space from around the cable and it is fixed only to the wall of the enclosure, the installation of a number of cables to be disposed close to each other is possible. The installation is mechanically extremely strong, and the parts according to the invention are inexpensive in terms of their costs.

### Short description of the drawings

In the following, the invention will be described in more detail by the aid some embodiments with reference to the attached drawings, wherein
Fig. 1 presents an electrical device disposed in an enclosure,
Fig. 2 presents an installation of a cable according to prior art,
Fig. 3A presents a bushing flange according to the invention,
Fig. 3B presents a section view along the line A-A of Fig. 3A,
Fig. 4A presents an installation of a cable according to the invention,
Fig. 4B presents a cable-clamping solution according to the invention.

### Detailed description of the invention

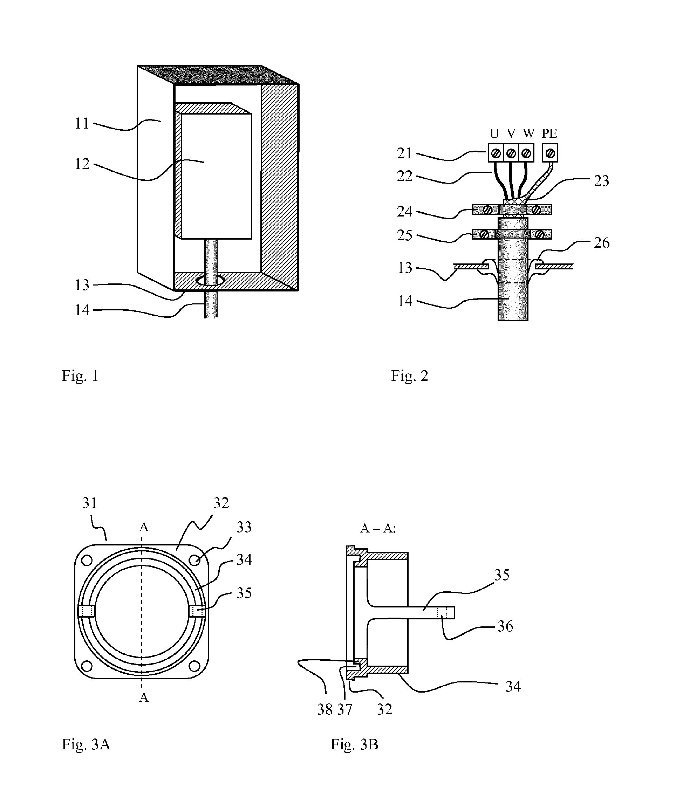

Fig. 1 presents a power electronics device 12 disposed inside an enclosure 11, which device can be e.g. a frequency converter. The electric cables 14 coming to the device enter the enclosure typically through the base plate 13, which installation direction reduces the probability of the ingress of splashes. Differing from the simplified example of the figure, the installation normally comprises a number of different cables, such as e.g. power supply cables, motor cables and control cables. There can be a number of devices, with their own cabling, inside the same enclosure entity.

Fig. 2 contains an example of a known cable installation method in the lead-in of the enclosure and inside the enclosure. The tightness required by the protection class in the aperture of the base plate 13 can be implemented with a ring-shaped rubber seal 26, onto the outside rim of which a groove is fitted for fixing to the base plate. The center part of the seal is typically solid, in which case an aperture is pierced in it for configuring the cable 14 to fit through the seal.

Next, as viewed from the input direction of the cable, on the inside of the enclosure is a cable clamping arm 25, which is fixed to its mounting base e.g. with screws. The cable remains tightly pressed between the arm and the mounting base, in which case it stays in its position without stressing the electrical connections.

The EMC earthing of the cable can be performed according to the figure by removing the topmost insulating envelope for the necessary distance in which case the metal sheath 23 is exposed, and by installing as tightly as possible against the sheath an earthing arm 24, which is in electrically conductive contact also with the enclosure.

Both the cable clamping arm and the earthing arm can be fixed to the rear wall of the enclosure or to a separate mounting base that is in galvanic contact with the enclosure.

In the example of Fig. 2 the phase conductors 22, which are connected to the phase connectors U, V, W of a power electronics device, are also visible as well as the earth connector PE, to which the sheath of the cable or a separate earthing wire can be connected.

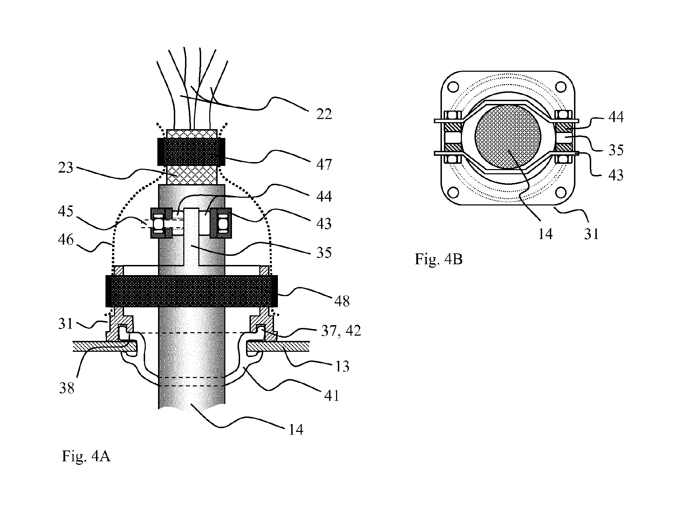

Fig. 3A presents a preferably one-piece bushing flange 31 according to the invention as viewed from the longitudinal direction of the cable going through it, and Fig. 3B presents it as seen from the cross-section line A - A. The flange comprises a mounting base part 32, which can be square-shaped with rounded corners according to the embodiment of the figure, and in which there are fixing holes 33 for fixing the flange e.g. with screws to the base plate of the enclosure. Since both the flange and the base plate are fabricated from electrically conductive metal, in a normal installation an electrical connection belonging to the earthing arrangement forms between them. The bushing flange 31 also comprises a round frame part 34 and at least one, preferably two, fixing tongues 35 in the longitudinal direction of the cable, which tongues have holes 36 for the fixing of the cable clamping arm 43 (Fig. 4A). The fixing tongues can also be separate parts, which are fixed to the frame part of the bushing flange e.g. with screws. On the inside rim of the frame part 34 on the mounting base end are a ring-shaped fixing groove 37 ensuring immovability of the lead-in seal and a fixing edge 38.

Fig. 4A presents a cross-section of the installation of a cable by the aid of a bushing flange 31 according to the invention. In the installation the cable 14 is pushed through the round aperture situated in the base plate 13. A ring-shaped sealing part 41 of a flexible material, such as e.g. rubber, is also disposed in the aperture, which sealing part ensures that the cable installation is according to the tightness class required of the enclosure and which sealing part is configured to press from its inside rim tightly around the cable and to be supported by its outside rim on the edges of the base plate 13. The sealing part also comprises a ring-shaped protrusion 42, which is configured to fit into the fixing groove 37 of the bushing flange, that together with the compressing effect of the fixing edge 38 ensures that the sealing part stays in its position and therefore that the desired tightness class is met after the flange has been fixed into its position.

The mechanical immovability of the cable is ensured with cable clamping, in which cable clamping arms 43 that tightly press the cable are fixed e.g. with fixing bolts 45 to the arm 33 of the lead-in part 31. In the installation intermediate pieces 44 e.g. fabricated from rubber can be used for achieving flexible compression. Fig. 4B further presents a cross-section illustrating the cable clamping as viewed from the longitudinal direction of the cable.

For EMC earthing the outer insulation layer is stripped off the end of the cable, in which case the metal earthing sheath 23 is exposed. For earthing the flange a flexible earthing sock 46 e.g. fabricated from metal netting is threaded around the cable, which metal netting is pressed e.g. with clamps 47, 48 generally used in piping installations around both the bare sheath 23 and the frame of the lead-in part.

It is obvious to the person skilled in the art that the different embodiments of the invention are not limited solely to the example described above, but that they may be varied within the scope of the claims presented below.

## Claims

1. Arrangement for connecting an electric cable (14) to a power electronics device (12), such as to a frequency converter, which device is protected with an enclosure (11), through the wall structure of which enclosure the cable is arranged, and in which arrangement the cable is supported for reducing the mechanical stressing of the electrical connections (cable clamping),
**characterized in that**
the arrangement comprises an electrically conductive metal bushing flange (31), through which the cable (14) is arranged to pass into the enclosure (11),
which flange (31) is fixed to the wall structure of the enclosure (11), e.g. with screws, and
which flange (31) comprises at least one fixing tongue (35) for fixing the cable clamp bars (43) of the cable.

2. Arrangement according to claim 1, wherein also the metal protective sheath (23) of the cable is earthed essentially on every side (360° earthing), and the lead-in aperture of the cable is sealed for preventing foreign objects, dust and splashes from intruding inside the enclosure,
**characterized in that** the inner rim of the flange (31) has a ring-shaped groove (37) in the longitudinal of the cable, into which groove a ring-shaped protrusion (42) belonging to the sealing part of the lead-in aperture is configured to fit.

3. Arrangement according to claim 1 or 2, **characterized in that** the inner rim of the flange (31) has a ring-shaped fixing edge (38) in the longitudinal direction of the cable, which is configured to press the sealing part (42) when the flange (31) is fixed into its position.

4. Arrangement according to any of claims 1-3, **characterized in that** a fixing tongue (35) is in the longitudinal direction of the cable (14).

5. Arrangement according to any of claims 1-4,
**characterized in that** the cable (14) is earthed by means of a flexible metal sock (46), which sock is fixed at one of its ends around the metal protective sheath (23) of the cable (14) and at the other of its ends around the frame part (34) of the bushing flange (31).

6. Arrangement according to any of claims 1-5,
**characterized in that** both the flange and the wall structure of the enclosure are fabricated from electrically conductive metal, in which case an electrical connection belonging to the earthing arrangement forms between them.
